(19) Europäisches Patentamt / European Patent Office / Office européen des brevets

(11) **EP 2 756 876 A1**

(12) **EUROPEAN PATENT APPLICATION**

(43) Date of publication:
**23.07.2014 Bulletin 2014/30**

(51) Int Cl.:
**B01D 53/00** (2006.01)     **B01D 53/68** (2006.01)
**C23C 16/44** (2006.01)

(21) Application number: **14151667.4**

(22) Date of filing: **17.01.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **17.01.2013 US 201361753635 P**
**07.01.2014 US 201414149318**

(71) Applicant: **Air Products and Chemicals, Inc.**
**Allentown, PA 18195-1501 (US)**

(72) Inventors:
• **Johnson, Andrew David**
  **Doylestown, PA 18901 (US)**

• **Agarwal, Rajiv Krishan**
  **Malvern, PA 19355 (US)**
• **Ahn, Heui-Bok**
  **Gyeonggi-do 445-160 (KR)**
• **Casteel, Jr., William Jack**
  **Emmaus, PA 18049 (US)**
• **Karwacki, Jr., Eugene Joseph**
  **Orefield, PA 18069 (US)**
• **Lehmann, John Francis**
  **Bethlehem, PA 18018 (US)**
• **Winchester, David Charles**
  **Walnutport, PA 18088 (US)**

(74) Representative: **Beck Greener**
**Fulwood House**
**12 Fulwood Place**
**London WC1V 6HR (GB)**

(54) **System for tungsten hexafluoride recovery and reuse**

(57) Condensable materials, such as but not limited to tungsten fluoride ($WF_6$), can be used deposit films in a chemical vapor deposition (CVD) process. Described herein are methods to collect and reuse the condensable materials that are unreacted in the production process rather than treat these materials as waste. In one embodiment, when a condensable material, such as gaseous $WF_6$, is not supplied to the CVD reactor, it is redirected to a recovery cabinet for capture.

FIG. 1

EP 2 756 876 A1

**Description**

BACKGROUND OF THE INVENTION

Described herein are systems and methods for recovery of semiconductor manufacturing materials, such as for example, tungsten hexafluoride ($WF_6$). Also described herein are systems and methods that recover and then reuse the semiconductor manufacturing materials for semiconductor manufacturing.

Tungten hexafluoride ($WF_6$) is a condensable material that is used in the manufacture of semiconductor devices. $WF_6$ is manufactured for use in semiconductor manufacturing processes, and is typically used as a reactant in the chemical vapor deposition (CVD) formation of tungsten films. A common way to synthesize $WF_6$ is by the highly-exothermic reaction of elemental fluorine ($F_2$) and tungsten metal as shown in reaction (1) below:

$$W(s) + 3F_2 = WF_6(g) \ (\Delta H^o = \text{-418 kcal/mol}) \qquad \textit{Reaction (1)}$$

During CVD processing, the $WF_6$ is not efficiently utilized. Unreacted $WF_6$ is directed to the reactor exhaust and disposed as waste. Typically, $WF_6$ is hydrolyzed using a wet scrubber, generating waste-water containing aqueous hydrofluoric acid (HF (aq)) and tungsten oxides ($WO_x$). This waste-water must then be treated at a waste-water treatment facility before it can be discharged.

Accordingly, there is a need to provide a method, system, apparatus or combinations thereof for capturing the $WF_6$ and other condensable materials such that they can then be reused and/or recycled in a production process. There is a need in the art to reduce the usage costs of condensable materials such as $WF_6$ which are delivered to a production tool in, for example, a CVD process. There is a further need in the art to reduce the waste of condensable materials that are used in the production process.

BRIEF SUMMARY OF THE INVENTION

The method, system, and apparatus described herein fulfill at least one of the needs in the art. In one aspect of the invention, there is provided an apparatus for capture and recovery of a condensable material from a chemical process reactor that uses the condensable material, comprising;

    (a) a process controller
    (b) a chemical process reactor provided with one or more lines for introducing the condensable material into the chemical process reactor, said one or more lines being in electrical communication with the process controller;
    (c) an effluent line from the chemical process reactor capable of removing unreacted condensable material from the chemical process reactor;
    (d) optionally a check valve, having a set cracking pressure, in the effluent line allowing removal of the unreacted condensable material from the chemical process reactor and preventing any substantial flow of effluent to the chemical process reactor;
    (e) a recovery vessel, further comprising a cooling jacket in electrical communication with the process controller, and capable of housing the unreacted condensable material;
    (f) a recovery line having a connection to the chemical process reactor or the effluent line, upstream of the optional check valve, capable of removing the unreacted condensable material from the chemical process reactor or effluent line and sending it to the recovery vessel; and
    (g) an automatic valve in the recovery line having a signal connection to the process controller.

In another aspect of the invention, there is provided a system for the capture and recovery of a condensable material from a chemical process reactor that uses the condensable material, comprising;

    a process controller;

    a chemical process reactor provided with one or more lines for introducing the condensable material into the chemical process reactor, said one or more lines being in electrical communication with the process controller;

    an effluent line from the chemical process reactor capable of removing unreacted condensable material from the chemical process reactor;

optionally, a check valve, having a set cracking pressure, in the effluent line allowing removal of the unreacted condensable material from the chemical process reactor and preventing any substantial flow of effluent to the chemical process reactor;

a recovery vessel, further comprising a cooling jacket in electrical communication with the process controller, and capable of housing the unreacted condensable material;

a recovery line having a connection to the chemical process reactor, or effluent line, upstream of the optional check valve, capable of removing the unreacted condensable material from the chemical process reactor or effluent line and sending it to the recovery vessel; and

an automatic valve in the recovery line having a signal connection to the process controller.

Further aspects of the invention include the following aspects, numbered #1 to #7:

Aspect #1. An apparatus for a recovery of a condensable material from a chemical process reactor that uses the condensable material, comprising;

(a) a chemical process reactor provided with one or more lines for introducing the condensable material in electrical communication with a process controller;
(b) an effluent line from the chemical process reactor capable of removing an unreacted condensable material introduced into the chemical process reactor;
(c) a recovery line having a connection to the effluent line wherein the recover line is upstream of the check valve and wherein the recovery line and sends the unreacted condensable material from the effluent line and to a recovery vessel;
(d) an automatic valve in the recovery line having a signal connection to the process controller;
(e) a process controller; and,
(f) the recovery vessel further comprising a cooling jacket in electrical communication with the process controller and capable of housing the unreacted condensable material.

Aspect #2. The apparatus of Aspect #1 wherein the condensable material comprises $WF_6$.

Aspect #3. The apparatus of Aspect #1 wherein the condensable material comprises an organosilane.

Aspect #4. The apparatus of Aspect #1 wherein the condensable materials comprises an organometallic.

Aspect #5. The apparatus of Aspect #1 wherein the recovery vessel which collects the condensable material further comprises KF as a complexing agent.

Aspect #6. The apparatus of Aspect #1 wherein the recovery vessel comprises nickel.

Aspect #7. The apparatus of Aspect #1 wherein the recovery vessel is comprised of a nickel-plated material.

BRIEF DESCRIPTION OF SEVERAL VIEWS OF THE DRAWINGS

Figure 1 provides a process flow-diagram of one embodiment for recovering a condensable material such as $WF_6$ for future re-use.
Figure 2 provides the liquid-vapor phase diagram for $WF_6$, with vapor pressure (in Torr) along the y axis and temperature (in degrees Fahrenheit) along the x axis. The solid line represents the phase boundary between condensed $WF_6$ and gaseous $WF_6$. For conditions above the solid line, $WF_6$ exists as a liquid or solid. For conditions under the solid line, $WF_6$ exists as a gas.
Figure 3 provides an example of one embodiment of the equipment and system used to capture and recover a condensable material such as $WF_6$.

DETAILED DESCRIPTION OF THE INVENTION

Material recovery provides an opportunity to reduce the cost and amount of waste generated by semiconductor manufacturing processes. Effluents from semiconductor processes may include valuable materials, such as $WF_6$ or

other condensable materials, that can be recovered for reuse rather than being treated as waste. Material recovery improves the utilization efficiency of, and reduces the amount of waste generated by, the manufacturing process. While the method, system and/or apparatus described herein is used for capturing and reusing tungsten hexafluoride ($WF_6$), the methods, systems, and/or apparatus described herein, can be extended to other condensable materials.

Described herein is a means to recover desirable condensable materials, such as but not limited to $WF_6$, in yields that minimize production waste and allow the condensable materials to be captured and stored for re-use in the manufacturing process. $WF_6$ delivered to the production tool, but not utilized in the CVD of tungsten films, is directed to the reactor exhaust and was in the past then disposed of as waste. The method, apparatus, and system described herein allows for the production waste or unreacted $WF_6$ to be captured in a storage vessel, such as a cylinder, and then reused for future production. Several methods of capture are contemplated: condensation, complexation, and combinations thereof. These capture methods store the $WF_6$ in a condensed phase in a vessel, in a support, or a combination thereof. The $WF_6$ can subsequently be reused by heating the vessel and/or a support within the vessel and vaporizing the $WF_6$. Exemplary yields obtainable for the $WF_6$ or condensable material for reuse using the method described include one or more of the following endpoints: 10 vol % or greater, 20 vol % or greater, 30 vol % or greater, 40 vol % or greater, 50 vol % or greater, 55 vol % or greater, 60 volume % or greater, 65 vol % or greater, 70 vol % or greater, 75 vol % or greater, 80 vol % or greater, or 90 vol % or greater based on the gross material supply. Also described herein is an apparatus and system that efficiently captures the $WF_6$ for reuse in production.

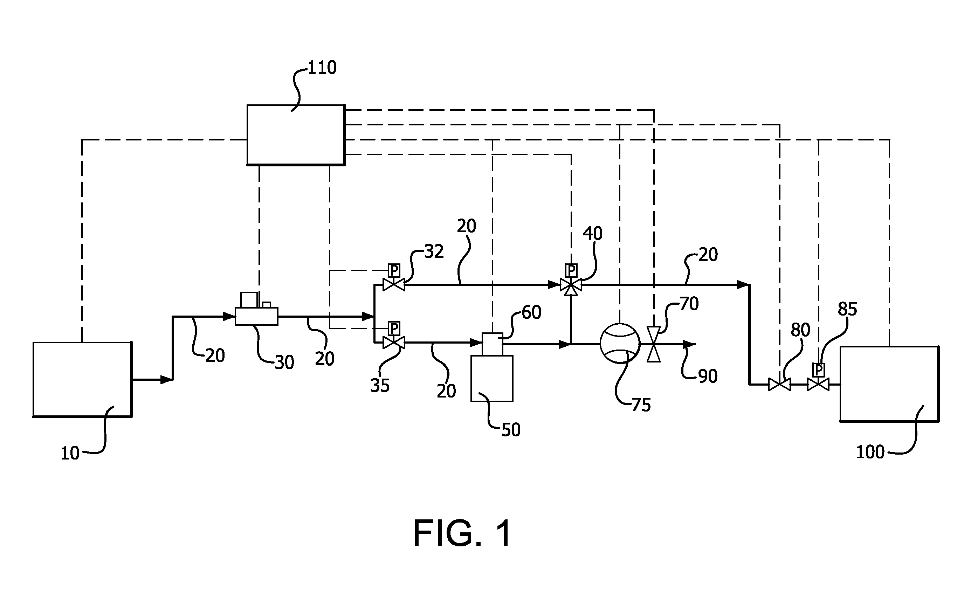

Figure 1 depicts one embodiment of the method described herein. As Figure 1 illustrates, $WF_6$ is provided as a gas from supply cabinet 10 which may further include a storage vessel such as a storage cylinder (not shown in Figure 1) to contain the $WF_6$. The materials of construction of the storage cylinder (not shown), recovery cylinder (not shown), and process lines 20 should be preferably meet one or more of the following parameters: be corrosion-resistant and withstand process temperatures up to approximately 111°C or 232°F. With regard to being corrosion-resistant, in certain applications, the end-user may passivate one or more portions of process line 20 by introducing a fluorine gas, such as elemental fluorine ($F_2$), to remove any adsorbed moisture or hydroxides which can react with $WF_6$ and form undesirable by-products such as HF. Suitable materials for process line 20 and the storage and/or recovery cylinders include stainless steel. In certain embodiments, the material for the process line may be comprised of nickel, nickel alloys, or nickel plated stainless steel. Supply cabinet 10 is in fluid communication with production tool 50 which further comprises a deposition reactor 60 to which the $WF_6$ is supplied to in gaseous form via process line 20 via mass flow controller 30 which can provide uninterrupted supply of $WF_6$ to the production tool 50 and deposition reactor 60. Production tool 50 assists in the performance of various steps of semiconductor fabrication, including deposition of a tungsten film on a surface of a semiconductor substrate by CVD, in deposition reactor 60. The production tool 50 may comprise one or more deposition reactors 60. The substrate may be comprised of one or more semiconductor wafers such as a "boat" or carrier of a series of wafers stacked on their edge. The substrate can be introduced into the reactor 60 through a load lock from a load chamber (not shown) in production tool 50. As shown in Figure 1, mass flow controller 30 controls the flow of $WF_6$ delivered to deposition reactor 60 to a certain flow rate, such as, for example, 300 standard cubic centimeters (sccm). However, the flow rate and other attributes of flow of $WF_6$ to production tool 50 and deposition reactor 60 can be controlled via the end user. Whenever $WF_6(g)$ is not supplied to the deposition reactor 60, it can be re-directed to a recovery cabinet 100 for capture in a storage vessel such as a recovery cylinder (not shown in Figure 1) via two-way valve 32, three-way valve 40, two-way valve 80, and two-way valve 85 thereby by-passing process tool 50 and deposition reactor 60.

During processing, $WF_6(g)$ is supplied to deposition reactor 60. Any unreacted $WF_6$ can be directed via process line 20 to automatic valve 40, through two valves 80 and 85 and collected in one or more storage vessels (not shown) in recovery cabinet 100. Alternatively, un-reacted $WF_6$ or any effluent gas such as passivation or purge gas can be directed to check-valve 70 after vacuum pump 75 and thereafter to the production facility exhaust 90 for the purpose of purging the line. Effluent that passes through the check valve 70 is sent into an abatement, scrubbing and production facility exhaust system (not shown) through fab exhaust line 90 to decompose, burn or sorb toxic, hazardous, corrosive or global warming gases.

Figure 1 further shows central processing unit CPU or process controller 110 which is in electrical communication as shown by the dashed line in Figure 1 with any one or more of the elements of the system shown in Figure 1, such as: $WF_6$ supply cabinet 10; mass flow controller 30; valves 35, 32, 40, 70, 80, and/or 85; vacuum pump 75; process tool 50; deposition reactor 60, and/or $WF_6$ recovery cabinet 100. In one embodiment, the process controller 110 can monitor the process tool 50 and deposition tool 60 and adjust its temperature, control plasma conditions and maintain pressures to set parameters. Process controller 110 can by electrical communication with mass flow controller 30 monitor and/or control mass flow controller 30, such that a certain flow rate and sequence of $WF_6$ is introduced into the reactor 60.

Process controller 110 can further control any one or more of valves 35, 32, 40, 70, 80, and/or 85 via electrical communication. Unreacted $WF_6$ from the reactor 60 can be drawn away from process tool 50 into an exhaust effluent vacuum pump 75, through check-valve 70 and to the fab exhaust line 90. In one particular embodiment, check-valve 70 is set with a minimum cracking pressure, which represents the pressure at which it will open to allow flow and below which it will close to prevent backflow toward the reactor 60.

As previously mentioned, WF$_6$ recovery cabinet 10 in Figure 1 can be isolated from the process tool 50 and deposition reactor 60 by closing valve 35, 32, and 40. This timing, sequence and delayed, phased time to discretely remove and recover the WF$_6$ from its continuous flow is monitored and/or controlled by the process controller 110 through one or more signal connections (not shown) to the automatic valve 85. The process controller (110) controls mass flow controller (30) to supply WF$_6$ to the deposition reactor 60. During a deposition, WF$_6$ flows through process line 20, mass flow controller 30 and valve 35. Unconsumed WF$_6$ and other deposition byproducts exit the deposition reactor 60 through exhaust line 90, vacuum pump 75 and check valve 70. Alternatively, during the deposition, the unused WF$_6$ from the deposition reactor 60 can be collected by directing the effluents to the recovery cabinet 100 through valve 40, process line 20, and valves 80 and 85. When deposition is complete and WF$_6$ need not be supplied to deposition reactor 60, as determined by the process controller 110, valve 35 is closed and WF$_6$ is directed to the recovery cabinet 100 through valve 32, process line 20, three-way valve 40, and valves 80 and 85.

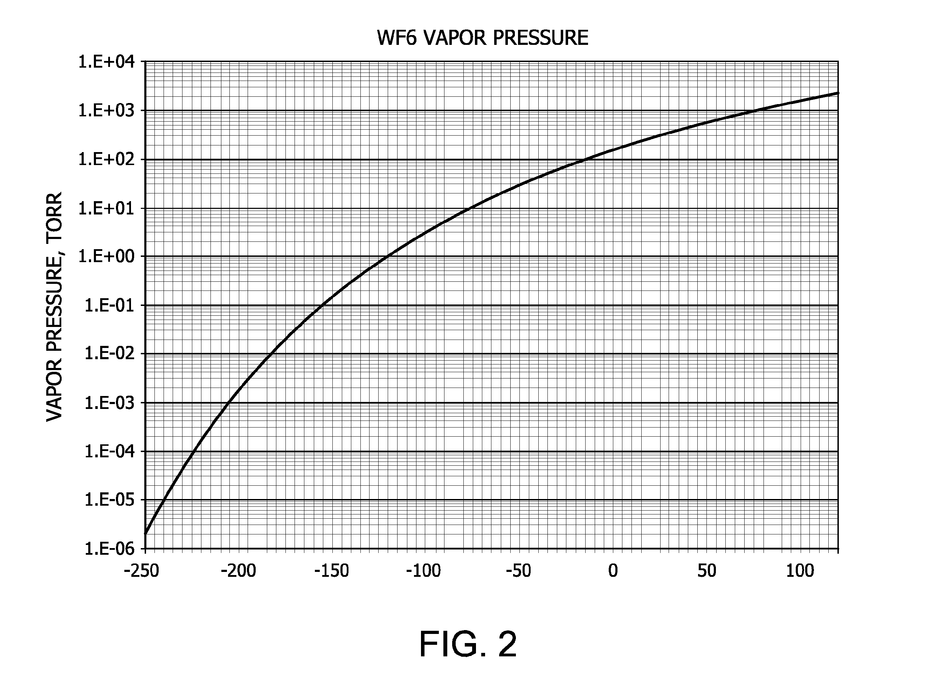

As previously mentioned, the method, system and apparatus described herein may use one of several methods for capture of a condensable material: condensation, complexation, or a combination thereof. In one embodiment, the condensable material such as WF$_6$ is captured via condensation. Referring to the phase diagram in Figure 2, condensation involves collecting WF$_6$ in a storage vessel under temperature and vapor pressure conditions where the phase diagram shows WF$_6$ to be a liquid or solid, which is generally the area above the solid line in Figure 2 (e.g., relatively higher vapor pressure and lower temperature). Capture by condensation is achieved by operating the capture vessel under temperature conditions such that the condensable material is a liquid or solid as indicated by its phase-diagram. In one particular embodiment of the method and system described herein, the temperature of the recovery cylinder or collection vessel is measured using a temperature sensor or thermocouple. In this or other embodiments, the pressure of recovery cylinder or the collection vessel is measured by a pressure transducer. For WF$_6$, at a pressure of 1000 torr (133 kPa), the temperature must be lower than 21°C or 70°F. Preferably, the conditions of temperature and pressure are 13°C or 55°F and 700 torr (93 kPa), respectively. In this way, the gaseous WF$_6$(g) from the process can be recovered for reuse by heating the recovery cylinder or collection vessel to increase the WF$_6$ vapor pressure. For example, if the collection vessel is warmed to room temperature (21°C or 70°F), the vapor pressure is 1000 torr (133 kPa). Under these conditions, the recovered WF$_6$(g) can be delivered to the process tool or deposition reactor.

In an alternative embodiment, capture of the condensable material by complexation is achieved by filling the recovery cylinder or collection vessel with a support such as, without limitation, activated potassium fluoride (KF). An activated KF support could capture the gaseous WF$_6$(g) material as a mixture of solid KWF$_7$(s) and K$_2$WF$_8$(s). The gaseous WF$_6$(g) is recovered for reuse by heating the KF support to approximately 100°C or 212°F to release gas phase WF$_6$(g). In a further embodiment, a zirconium or alumina support could be used to enhance adsorption by providing a higher surface area for complexation. In yet another embodiment, a finely-divided powder could be used. In the foregoing embodiments, the solid or support containing the captured tungsten can be heated under suitable conditions, such as suitable temperatures and/or pressures, to release WF$_6$(g) from the solid or support.

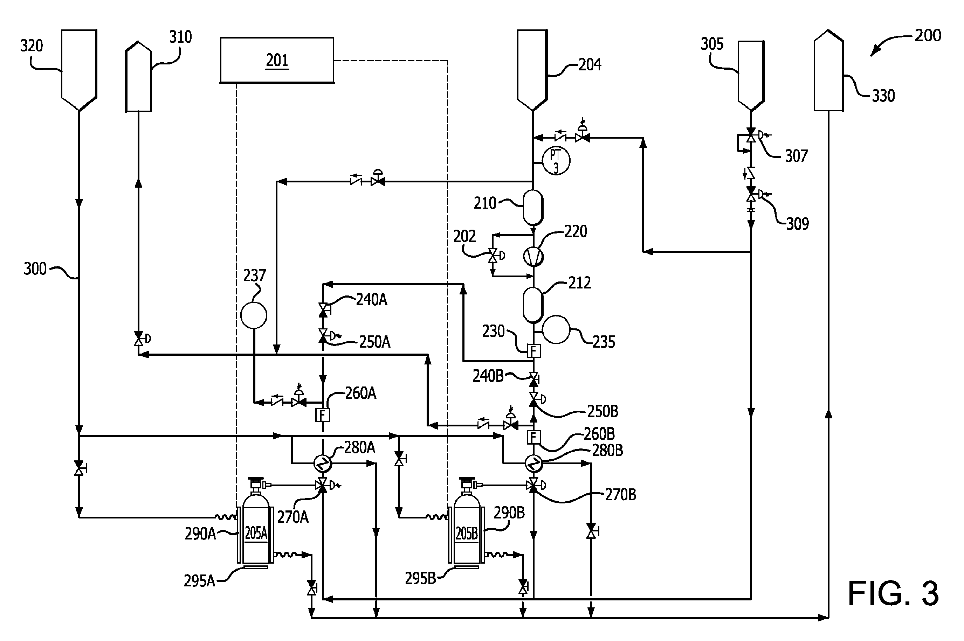

Figure 3 provides an embodiment of a system 200 for capturing and recovering WF$_6$. The unreacted WF$_6$ effluent from the process is introduced via feed line 204 through buffer tank 210 and compressed using compressor 220. The WF$_6$(g) partial pressure is measured using pressure transducer 235. Back-pressure regulator 202 is optional. The gas phase WF$_6$ is transported to the storage vessel 205A through filter 230, shutoff valves 240A, 250A, filter 260A and valve 270A. There is a redundant backup system wherein the WF$_6$(g) can be re-directed to storage vessel 205B through filter 230, and then through shutoff valves 240B and 250B, filter 260B and valve 270B. An optional condenser 280A or 280B (depending upon the side) can cool the WF$_6$ gas before the WF$_6$ is condensed in vessel 205A (or 205B) that is cooled with a cooling jacket 290A (or 290B). Conditions of about 13°C or 55°F temperature and 700 torr (93 kPa) pressure are preferred since this can be achieved using chilled water line in fluid communication with the cooling water supply via process line 300 and a diaphragm compressor (not shown). A scale or level sensor 295A or 295B indicates when the vessel 205A or 205B, respectively, is full and needs to be replaced with another vessel.

Central processing unit or process controller 201 is in electrical communication with any one or more of the elements provided in Figure 3. For example, in the embodiment shown in Figure 3, process controller 201 can be in electrical communication with one or more sensors associated with storage vessels 205A and/or 205B to monitor its temperature, pressure, capacity or other relevant parameters. However, process controller 201 can be in electrical communication with additional elements of system 200 which are not shown in the Figure.

In another embodiment of the system in Figure 3, an additional compressor, such as optional compressor 220, may not be needed. In this system, vessel 205A and/or 205B can be cooled to about -10°C or 14°F or lower. WF$_6$ is a solid at about -10°C or 14°F with a vapor pressure of 255 torr (34 kPa). In the capture mode, the recovery WF$_6$ is directed to vessel 205A or 205B without the compressor. In this embodiment, the feed line pressure must be higher than 255 torr at this stage. Once vessel 205A or 205B is full as indicated by scale 295A or 295B, it can be replaced by another vessel. After its filled, vessel 205A or 205B can be warmed up to room temperature to provide a source of pure WF$_6$.

Cylinder change and automatic cross-over techniques normally practiced enable continuous recovery operations. Figure 3 illustrates an embodiment of the system that comprises a 2 cylinder cabinet for capture of WF$_6$. When

vessel 205A is full, the cylinder valve 250A is closed and $WF_6$ directed to vessel 205B. The unreacted $WF_6$ effluent is introduced through buffer tank 210 from feed line 200 and compressed using compressor 220. An additional buffer tank 212 is added to the line to take out any pressure pulsation caused by compressor 220. The $WF_6(g)$ partial pressure is measured using transducer 235. The gas phase $WF_6$ is transported to the storage vessel 205B through filter 230, shutoff valves 240B, 250B, filter 260B, and valve 270B. An optional condenser 280B can cool the $WF_6$ gas before the $WF_6$ is condensed in a vessel 205B that is cooled with a cooling jacket 290B. Conditions of about 13°C or 55°F temperature and 700 torr (93 kPa) pressure are preferred since this can be achieved using chilled water and a diaphragm compressor. Similar to the "A" side, scale 295B indicates when the vessel is full and needs to be replaced with another vessel. Cylinder change and automatic cross-over techniques normally practiced enable continuous recovery operations.

Figure 3 also shows process lines for various utilities (e.g., vacuum 310, purge line 305 such as $N_2$) which may be optionally needed, for example, for cylinder change operations normally practiced in gas delivery to process reactors. Cooling water is supplied to condensers 280A and 280B and cooling jackets 290A and 290B through cooling water input 320 through line 300 and cooling water return 330.

Once the collection vessels 205A, 205B, or combinations thereof are full, they are removed from the recovery cabinet system using purge and evacuation techniques normally practiced to prevent corrosion and operator exposure. These techniques may be automated using a process controller 210 in electrical communication with one or more automatic valves within the same system. The collection vessels 205A and/or 205B can then be moved to a supply cabinet which is used to supply $WF_6$ to the process reactor such as, without limitation, $WF_6$ supply cabinet 10 in Figure 1.

In the systems and embodiments described herein, it is preferable that the surfaces in contact with liquid $WF_6$ should ideally be nickel or nickel-plated to prevent its contamination with metals. In this regard, the chromium component of stainless steel alloys may volatize as chromium fluorides. Nickel is more resistant to corrosion than stainless steel. In one embodiment of the system of Figure 3, collection vessels 205A and 205B can be made of nickel or be nickel-plated. In these or other embodiments, the captured $WF_6$ remains uncontaminated and can then be reused in the original manufacturing process without any need for purification.

In one embodiment, the $WF_6$ recovery cabinet and supply cabinet can be combined in one system. In this embodiment, an integrated supply and recovery cabinet enables recovery and reuse without the need for cylinder change necessary for a stand alone recovery cabinet. Gas phase $WF_6$ can be supplied from one vessel in the cabinet and recovered as a liquid in the other vessel. This system may further comprise a third cylinder to allow continual operation. In this or other systems, a central recovery cabinet allows recovery of $WF_6$ from multiple process reactors. The size of collection vessels in the recovery cabinet would be chosen based upon the number of process reactors and their $WF_6$ usage.

While the embodiments shown herein are described using $WF_6$ as the condensable material, it is anticipated that other condensable material that can be recovered and recycled could be, for example, a deposition precursor such as an organosilane or an organometallic material. In one embodiment, the chemical process reactor is a deposition chamber such as a chemical vapor deposition reactor or an atomic layer deposition reactor. Excess deposition precursor materials such as an organosilane or an organometallic material can be recovered from the deposition chamber and captured for reuse using the system and method described herein. Exemplary organosilane materials include, without limitation, disilane, tetrasilane, pentasilane, di-isopropylaminosilane, or combinations thereof. Exemplary organometallic materials include any materials having an organic component and one or more of the following metals Ru, Ti, Zr, Hf, Cu, Al, Ta, Zn, W, Nb, Mo, Mn, Ce, Gd, Sn, Co, Mg, Sr, La, and combinations thereof.

## Claims

1. An apparatus for a recovery of a condensable material from a chemical process reactor that uses the condensable material, comprising;

    (a) a process controller;
    (b) a chemical process reactor provided with one or more lines for introducing the condensable material into the chemical process reactor, said one or more lines being in electrical communication with the process controller;
    (c) an effluent line from the chemical process reactor capable of removing unreacted condensable material from the chemical process reactor;
    (d) a recovery vessel, further comprising a cooling jacket in electrical communication with the process controller, and capable of housing unreacted condensable material;
    (e) a recovery line having a connection to the chemical process reactor or to the effluent line and capable of removing unreacted condensable material from the chemical process reactor or effluent line and sending the unreacted condensable material to the recovery vessel; and
    (f) an automatic valve in the recovery line having a signal connection to the process controller.

**2.** The apparatus of claim 1, wherein the apparatus further comprises a check valve in the effluent line, and wherein the recovery line is connected to the chemical process reactor or to the effluent line upstream of the check valve.

**3.** The apparatus of claim 1 or 2 wherein the condensable material comprises $WF_6$.

**4.** The apparatus of claim 1 or 2 wherein the condensable material comprises an organosilane.

**5.** The apparatus of claim 1 or 2 wherein the condensable materials comprises an organometallic.

**6.** The apparatus of any preceeding claim wherein the recovery vessel which collects the condensable material further comprises KF as a complexing agent.

**7.** The apparatus of any preceeding claim wherein the recovery vessel comprises nickel.

**8.** The apparatus of any preceeding claim wherein the recovery vessel is comprised of a nickel-plated material.

FIG. 1

FIG. 2

FIG. 3

EP 2 756 876 A1

Europäisches
Patentamt

European
Patent Office

Office européen
des brevets

# EUROPEAN SEARCH REPORT

Application Number

EP 14 15 1667

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/304930 A1 (VERDICT GREGORY SCOTT [US] ET AL) 6 December 2012 (2012-12-06) * paragraph [0031]; figure 1 * * abstract * ----- | 1 | INV. B01D53/00 B01D53/68 C23C16/44 |
| X | US 2003/141016 A1 (OKASE WATARU [JP] ET AL) 31 July 2003 (2003-07-31) * figures 1,2 * ----- | 1,2 | |
| X | US 2010/075037 A1 (MARSH EUGENE P [US] ET AL) 25 March 2010 (2010-03-25) * paragraph [0031]; claim 7; figure 4 * ----- | 1,2 | |
| X | US 6 402 806 B1 (SCHMITT JOHN VINCENT [US] ET AL) 11 June 2002 (2002-06-11) * figure 5 * ----- | 1 | |
| X | US 2004/250765 A1 (ISHIZAKA TADAHIRO [JP] ET AL) 16 December 2004 (2004-12-16) * figures 2,3 * ----- | 1 | TECHNICAL FIELDS SEARCHED (IPC) |
| A | US 2009/191109 A1 (TSUDA EINOSUKE [JP]) 30 July 2009 (2009-07-30) * figure 1 * ----- | 1-8 | B01D C23C |

The present search report has been drawn up for all claims

| Place of search | Date of completion of the search | Examiner |
|---|---|---|
| The Hague | 15 May 2014 | Gruber, Marco |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 15 1667

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2014

| Patent document cited in search report | Publication date | Patent family member(s) | Publication date |
|---|---|---|---|
| US 2012304930 A1 | 06-12-2012 | US 2012304930 A1<br>WO 2012167195 A2 | 06-12-2012<br>06-12-2012 |
| US 2003141016 A1 | 31-07-2003 | JP 4092821 B2<br>JP 2001044185 A<br>US 2003141016 A1 | 28-05-2008<br>16-02-2001<br>31-07-2003 |
| US 2010075037 A1 | 25-03-2010 | CN 102160148 A<br>KR 20110046551 A<br>SG 194365 A1<br>TW 201016879 A<br>US 2010075037 A1<br>WO 2010033318 A2 | 17-08-2011<br>04-05-2011<br>29-11-2013<br>01-05-2010<br>25-03-2010<br>25-03-2010 |
| US 6402806 B1 | 11-06-2002 | JP 2001527158 A<br>TW 460605 B<br>US 6099649 A<br>US 6402806 B1<br>WO 9932686 A1 | 25-12-2001<br>21-10-2001<br>08-08-2000<br>11-06-2002<br>01-07-1999 |
| US 2004250765 A1 | 16-12-2004 | JP 4113755 B2<br>JP 2004124193 A<br>US 2004250765 A1<br>US 2007160757 A1 | 09-07-2008<br>22-04-2004<br>16-12-2004<br>12-07-2007 |
| US 2009191109 A1 | 30-07-2009 | CN 101356298 A<br>JP 5036354 B2<br>JP 2007300074 A<br>KR 20080106566 A<br>TW 200806807 A<br>US 2009191109 A1<br>US 2012031334 A1<br>WO 2007114427 A1 | 28-01-2009<br>26-09-2012<br>15-11-2007<br>08-12-2008<br>01-02-2008<br>30-07-2009<br>09-02-2012<br>11-10-2007 |

EPO FORM P0459

For more details about this annex : see Official Journal of the European Patent Office, No. 12/82